# EUROPEAN PATENT SPECIFICATION

(11) **EP 4 435 696 B1**
(45) Date of publication and mention of the grant of the patent: **29.07.2026**
(21) Application number: 23733614.4
(22) Date of filing: 15.03.2023
(51) Int. Cl.: G06Q 10/10, G06Q 10/20, G06Q 50/04

(54) **FORMING-MACHINE EQUIPMENT TESTING METHOD, APPARATUS, SYSTEM, AND COMPUTER READABLE STORAGE MEDIUM**
VERFAHREN, VORRICHTUNG, SYSTEM UND COMPUTERLESBARES SPEICHERMEDIUM ZUM TESTEN EINER FORMMASCHINEN AUSRÜSTUNG
PROCÉDÉ, APPAREIL ET SYSTÈME DE TEST D'UN ÉQUIPEMENT DE MACHINE DE FORMATION, ET SUPPORT D'ENREGISTREMENT LISIBLE PAR ORDINATEUR

(30) Priority: 07.02.2023 CN 202310084915
(43) Date of publication of application: 25.09.2024
(73) Proprietor: Contemporary Amperex Technology (Hong Kong) Limited, Central, Central And Western District (HK)
(72) Inventor: CHENG, Shaosheng, Ningde, Fujian 352100 (CN); YU, Wen, Ningde, Fujian 352100 (CN); GONG, Jiefei, Ningde, Fujian 352100 (CN); GUO, Fengyu, Ningde, Fujian 352100 (CN); WANG, Wei, Ningde, Fujian 352100 (CN); SONG, Weidong, Ningde, Fujian 352100 (CN); CHEN, Gege, Ningde, Fujian 352100 (CN)
(74) Representative: Rowlands, Stuart Michael
(86) International application number: PCT/CN2023/081729
(87) International publication number: WO 2024/164392

(56) References cited:
- CN-A- 105 911 475
- CN-A- 105 911 475
- CN-A- 105 911 475
- CN-A- 110 518 676
- CN-A- 110 518 676
- CN-A- 112 630 669
- CN-A- 112 630 669
- CN-A- 112 630 669
- JP-A- 2013 206 203
- JP-A- 2013 206 203
- US-A1- 2019 205 842

## Description

### TECHNICAL FIELD

This application relates to the field of forming machines, and in particular, to a forming-machine equipment testing method, an apparatus, a system, and a computer-readable storage medium.

### BACKGROUND

During battery preparation, a test equipment is generally required to implement a test process on a battery to test electrical parameters of the battery multiple times, so as to ensure that the electrical parameters of the battery always stay within the normal ranges.

At present, during a battery test, it is a general practice that the corresponding test equipment is manually transported to a corresponding location, and then a host computer is operated manually to control the test equipment to test the electrical parameters. However, it is laborious and inefficient to manually transport equipment and operate the host computer to perform electrical parameter testing.

Document US 2019/205842 A1 is part of the prior art.

### SUMMARY

In view of this, embodiments of this application are intended to provide a forming-machine equipment testing method, an apparatus, a system, and a computer-readable storage medium, enabling the forming-machine equipment to automatically execute test tasks, which reduces workload of workers while improving test efficiency.

The invention is defined in the independent claims 1, 6, and 11.

According to a first aspect, this application provides a forming-machine equipment testing method, applied to a forming-machine equipment testing system. The forming-machine equipment testing system includes a scheduling host computer, and the scheduling host computer stores a task start time corresponding to each type of equipment. The method includes: determining, by the scheduling host computer, an equipment transport task for the equipment after a task start time of the equipment is reached; determining, by the scheduling host computer, whether the equipment meets the equipment transport task; and if the equipment meets the equipment transport task, instructing, by scheduling host computer, an intelligent transport device to transport the equipment to a corresponding target location, so as to execute a test task for the equipment.

In the technical solution of the embodiments of this application, the task start time of each piece of equipment is prestored in the scheduling host computer. Therefore, the scheduling host computer can be triggered to directly generate a corresponding equipment transport task after the task start time is reached, implementing periodic automatic testing and reducing the workload of workers. In addition, before the intelligent transport device is controlled to transport the equipment, it is first determined whether the equipment meets the equipment transport task, and only when the equipment transport task is met, the intelligent transport device is controlled to transport the equipment to the corresponding target location. This reduces unexpected transport performed by the intelligent transport device and improves the testing efficiency of the forming-machine equipment.

In some embodiments, the forming-machine equipment testing system further includes a location host computer. The method further includes: after the intelligent transport device transports the equipment to the corresponding target location, determining, by the location host computer, a target test task corresponding to the equipment and delivering the target test task to the equipment. In the technical solution of the embodiments of this application, after the equipment is transported to the target location, the target test task corresponding to the equipment is automatically determined by the location host computer and delivered to the equipment. The entire process of generating a target test task is completed automatically by the location host computer without human intervention, reducing labor costs.

In some embodiments, the determining, by the location host computer, a target test task corresponding to the equipment includes: obtaining, by the location host computer, a graphic code of the equipment, and determining an equipment type of the equipment based on the graphic code; and determining, by the location host computer, the corresponding target test task based on the equipment type. In the technical solution of the embodiments of this application, the equipment type is determined based on the graphic code of the equipment, and each piece of equipment corresponds to a unique graphic code. The unique equipment type can be determined based on the graphic code because a test task corresponding to each equipment type remains unchanged. Therefore, the equipment type is determined based on the graphic code and then the target test task is determined accordingly. This can greatly avoid risks caused by executing a wrong task by equipment, and improve the accuracy of task execution by the equipment.

In some embodiments, the forming-machine equipment testing system further includes a location host computer. The determining, by the scheduling host computer, an equipment transport task for the equipment includes: receiving, by the scheduling host computer, a specified location input externally and determining the equipment transport task for the equipment based on the specified location. The method further includes: after the intelligent transport device transports the equipment to the specified location, receiving, by the location host computer, a target test task input externally and delivering the target test task to the equipment. In the technical solution of the embodiments of this application, when the target location corresponding to the equipment is under overhaul, the scheduling host computer is configured to determine a specified location according to information input externally, the location host computer is configured to obtain a target test task input externally, and the equipment is transported to the specified location for executing the target test task. Therefore, the test task for the equipment is completed manually. In this way, when the target location corresponding to the equipment is under overhaul, corresponding test tasks can be executed flexibly in another location, avoiding the case where equipment fails to execute a test task during overhaul of the target location and improving the flexibility of target test task execution by the forming-machine equipment.

In some embodiments, the determining, by the scheduling host computer, whether the equipment meets the equipment transport task includes: determining, by the scheduling host computer, whether the target location corresponding to the equipment meets an admission condition; if the target location meets the admission condition, determining, by the scheduling host computer, whether an equipment type of the equipment is an equipment type corresponding to a current test task; and if the equipment type of the equipment is an equipment type corresponds to the current test task, determining that the equipment meets the equipment transport task. In the technical solution of the embodiments of this application, whether the target location meets the admission condition and whether the equipment type is an equipment type corresponding to the current test task are determined separately. The equipment transport task is determined only when the target location meets the admission condition and the equipment type is the equipment type corresponding to the current test task. This prevents the intelligent transport device from performing unexpected transport in case of the equipment being inconsistent with the equipment type corresponding to the current test task and the target location being occupied, and improves the execution efficiency and accuracy of equipment transport tasks.

In some embodiments, the determining, by the scheduling host computer, whether an equipment type of the equipment is an equipment type corresponding to a current test task includes: obtaining, by the scheduling host computer, a graphic code of the equipment and determining the equipment type of the equipment based on the graphic code, so as to determine whether the equipment type of the equipment is an equipment type corresponds to the current test task. In the technical solution of the embodiments of this application, the graphic code of the equipment is obtained, and equipment type verification is performed on the to-be-transported equipment based on a binding relationship between graphic codes and equipment types, so as to determine that the to-be-transported equipment is of the equipment type corresponding to the current test task. In this way, equipment will not be transported by wrong, improving the accuracy of transport tasks.

In some embodiments, the method further includes: after the target test task is executed in the target location, obtaining, by the scheduling host computer, equipment data corresponding to the target test task executed by the equipment; determining, by the scheduling host computer, whether the equipment data meets an equipment backhauling task; and if the equipment data meets the equipment backhauling task, instructing, by the scheduling host computer, the intelligent transport device to transport the equipment back to an original location of the equipment. In the technical solution of the embodiments of this application, whether the equipment meets the equipment backhauling task is determined based on the equipment data, and when the equipment meets the transport task, the intelligent transport device is instructed to transport the equipment back to the original location, so as to periodically schedule each piece of equipment to execute corresponding test tasks. This allows the forming-machine equipment to execute test tasks automatically, reducing human intervention and labor costs while improving the test task execution efficiency of the forming-machine equipment.

According to a second aspect, an embodiment of this application further provides a system for executing a forming-machine equipment task, including a scheduling host computer. The scheduling host computer stores a task start time corresponding to each type of equipment , and the scheduling host computer is configured to: determine an equipment transport task for the equipment after a task start time of the equipment is reached; determine whether the equipment meets the equipment transport task; and if the equipment meets the equipment transport task, instruct an intelligent transport device to transport the equipment to a corresponding target location, so as to execute a test task for the equipment.

In the technical solution of this application, the task start time of each piece of equipment is prestored in the scheduling host computer. Therefore, the scheduling host computer can be triggered to directly generate a corresponding equipment transport task after the task start time is reached, implementing periodic automatic testing and reducing the workload of workers. Such periodic automatic testing simplifies management of test tasks for equipment and reduces errors in records and missed records for manual recording, further improving the testing accuracy of forming-machine equipment. In addition, before the intelligent transport device is controlled to transport the equipment, it is first determined whether the equipment meets the equipment transport task, and only when the equipment transport task is met, the intelligent transport device is controlled to transport the equipment to the corresponding target location. This reduces unexpected transport performed by the intelligent transport device and improves the testing efficiency of the forming-machine equipment.

In some embodiments, the system further includes a location host computer. The location host computer is configured to: after the intelligent transport device transports the equipment to the corresponding target location, determine a target test task corresponding to the equipment and deliver the target test task to the equipment. In the technical solution of the embodiments of this application, after the equipment is transported to the target location, the target test task corresponding to the equipment is automatically determined by the location host computer and delivered to the equipment. The entire process of generating a target test task is completed automatically by the location host computer without human intervention, reducing labor costs.

In some embodiments, the location host computer is further configured to: obtain a graphic code of the equipment and determine an equipment type of the equipment based on the graphic code; and determine the corresponding target test task based on the equipment type. In the technical solution of the embodiments of this application, the equipment type is determined based on the graphic code of the equipment, and each piece of equipment corresponds to a unique graphic code. The unique equipment type can be determined based on the graphic code because a test task corresponding to each equipment type remains unchanged. Therefore, the equipment type is determined based on the graphic code and then the target test task is determined accordingly. This can greatly avoid risks caused by executing a wrong task by a piece of equipment, and improve the accuracy of task execution by the equipment.

In some embodiments, the system further includes a location host computer. The location host computer is configured to: after the intelligent transport device transports the equipment to the corresponding target location, receive a target test task input externally and deliver the target test task to the equipment. In the technical solution of the embodiments of this application, when the target location corresponding to the equipment is under overhaul, the scheduling host computer is configured to determine a specified location according to information input externally, the location host computer is configured to obtain a target test task input externally, and the equipment is transported to the specified location for executing the target test task. Therefore, the test task for the equipment is completed manually. In this way, when the target location corresponding to the equipment is under overhaul, corresponding test tasks can be executed flexibly in another location, avoiding the case where a piece of equipment fails to execute a test task during overhaul of the target location and improving the flexibility of target test task execution by the forming-machine equipment.

In some embodiments, the scheduling host computer is further configured to determine whether the target location corresponding to the equipment meets an admission condition. The scheduling host computer is further configured to: if the target location meets the admission condition, determine whether an equipment type of the equipment is an equipment type corresponding to a current test task; and if the equipment type of the equipment is an equipment type corresponds to the current test task, determine that the equipment meets the equipment transport task. In the technical solution of the embodiments of this application, whether the target location meets the admission condition and whether the equipment type is an equipment type corresponding to the current test task are determined separately. The equipment transport task is determined only when the target location meets the admission condition and the equipment type is the equipment type corresponding to the current test task. This prevents the intelligent transport device from performing unexpected transport in case of the equipment being inconsistent with the equipment type corresponding to the current test task and the target location being occupied, and improves the execution efficiency and accuracy of equipment transport tasks.

In some embodiments, the scheduling host computer is further configured to obtain a graphic code of the equipment and determine the equipment type of the equipment based on the graphic code, so as to determine whether the equipment type of the equipment is an equipment type corresponds to the current test task. In the technical solution of the embodiments of this application, the graphic code of the equipment is obtained, and equipment type verification is performed on the to-be-transported equipment based on a binding relationship between graphic codes and equipment types, so as to determine that the to-be-transported equipment is of the equipment type corresponding to the current test task. In this way, a piece of equipment will not be transported by wrong, improving the accuracy of transport tasks.

In some embodiments, after the target test task is executed in the target location, the scheduling host computer is further configured to: obtain equipment data corresponding to the target test task executed by the equipment; determine whether the equipment data meets an equipment backhauling task; and if the equipment data meets the equipment backhauling task, instruct the intelligent transport device to transport the equipment back to an original location of the equipment. In the technical solution of the embodiments of this application, whether the equipment meets the equipment backhauling task is determined based on the equipment data, and when the equipment meets the transport task, the intelligent transport device is instructed to transport the equipment back to the original location, so as to periodically schedule each piece of equipment to execute corresponding test tasks. This allows the forming-machine equipment to execute test tasks automatically, reducing human intervention and labor costs while improving the test task execution efficiency of the forming-machine equipment.

According to a third aspect, an embodiment of this application further provides an electronic device, including a processor and a memory. The memory stores machine-readable instructions executable by the processor. During operation of the electronic device, when the machine-readable instructions are executed by the processor, the steps of the method according to the first aspect or any one of possible implementations of the first aspect are implemented.

According to a fourth aspect, this application provides a computer-readable storage medium, and the computer-readable storage medium stores a computer program. When the computer program is executed by a processor, the method according to the first aspect or any one of possible implementations of the first aspect is implemented.

According to a fifth aspect, this application provides a computer program product. When the computer program product runs on a computer, the method according to the first aspect or any one of possible implementations of the first aspect is implemented.

The foregoing description is merely an overview of the technical solution of this application. For a better understanding of the technical means in this application such that they can be implemented according to the content of the specification, and to make the above and other objectives, features and advantages of this application more obvious and easier to understand, the following describes specific embodiments of this application.

### BRIEF DESCRIPTION OF DRAWINGS

To describe the technical solutions of the embodiments of this application more clearly, the following briefly describes the accompanying drawings required for describing the embodiments. It is appreciated that the accompanying drawings below show merely some embodiments of this application and thus should not be considered as limitations on the scope. Persons of ordinary skill in the art may still derive other related drawings from the accompanying drawings without creative efforts.
FIG. 1 is a schematic diagram of an interaction between a location host computer and a scheduling host computer in a forming-machine equipment testing system according to an embodiment of this application;
FIG. 2 is a flowchart of a forming-machine equipment testing method according to an embodiment of this application;
FIG. 3 is a flowchart of automatic execution of a test task after an intelligent transport device transports a piece of equipment to a corresponding target location according to an embodiment of this application;
FIG. 4 is a flowchart of step S430 of a forming-machine equipment testing method according to an embodiment of this application;
FIG. 5 is a flowchart of manual execution of a test task after an intelligent transport device transports a piece of equipment to a corresponding target location according to an embodiment of this application;
FIG. 6 is a flowchart of step S410 of a forming-machine equipment testing method according to an embodiment of this application;
FIG. 7 is a flowchart of the forming-machine equipment testing method according to an embodiment of this application after a target test task is executed in a target location;
FIG. 8 is a schematic flowchart of an interaction between various devices in a forming-machine equipment testing system according to an embodiment of this application; and
FIG. 9 is a block diagram of an electronic device according to an embodiment of this application.

### DESCRIPTION OF EMBODIMENTS

The following describes in detail the embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by those skilled in the art to which this application relates. The terms used herein are intended to merely describe the specific embodiments rather than to limit this application. The terms "include", "comprise", and "have" and any other variations thereof in the specification, claims and brief description of drawings of this application are intended to cover non-exclusive inclusions.

In the description of the embodiments of this application, the terms "first", "second" and the like are merely intended to distinguish between different objects, and shall not be understood as any indication or implication of relative importance or any implicit indication of the number, sequence or primary-secondary relationship of the technical features indicated. In the description of this application, "a plurality of" means at least two unless otherwise specifically stated.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art that the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the description of the embodiments of this application, the term "a plurality of" means more than two (inclusive). Similarly, "a plurality of groups" means more than two (inclusive) groups, and "a plurality of pieces" means more than two (inclusive) pieces.

A forming machine is also referred to as a silicon-controlled battery charging and discharging machine, a battery charging and discharging power source, a battery forming device, or the like, which is suitable for a charging and discharging test during formation of electric bicycle batteries and electric vehicle batteries. The test can activate and increase the battery capacity of battery electrode plates. During battery production, various parameters of a battery need to be tested within a specified period of time, so as to ensure that the electrical parameters of the battery always stay within the normal ranges.

Existing forming-machine equipment typically includes multiple types of test equipment. A separate test equipment is provided for each electrical parameter test, so that each parameter of the battery can be tested separately. For example, a power source test equipment is used for testing a power source parameter of the battery, a temperature test equipment is used for testing a temperature parameter of the battery, a flatness test equipment is used for testing a flatness parameter of the battery, a pressure test equipment is used for testing a pressure parameter of the battery, and so on.

The inventors noticed that the existing testing method is: for testing an electrical parameter of a battery, a corresponding test equipment needs to be transported to a corresponding location in order to complete a test of a corresponding electrical parameter by using the test equipment in the location.

The inventors have found, through long-term research, that there are many types of test equipment for a forming machine and many corresponding locations, and each battery correspondingly has many electrical parameters to be tested. As a result, actual electrical parameter testing is a major task. At present, it is extremely laborious to manually transport a test equipment to a location, with low efficiency and high labor costs.

In addition, instead of being tested once, each electrical parameter of a battery needs to be tested at intervals to guarantee the testing accuracy. For example, a power source needs to be tested every half a year to ensure the accuracy of the power source test. However, at present, the test time of an electrical parameter usually needs to be recorded manually, and the corresponding equipment is controlled within a specified period of time to complete a test task. During manual recording, errors or missed record often occur. That is, a systematic record of use cannot be formed, which is not conducive to management of many types of equipment and corresponding test tasks.

Through in-depth research, the inventors have designed a forming-machine equipment testing method. In the method, task start time of each piece of equipment stored in a scheduling host computer is used to trigger the scheduling host computer to generate a transport task, and an intelligent transport device is instructed to transport the equipment to a target location for a test task. This implements automatic triggering of test tasks, avoiding possible omission during manual recording and startup of the test tasks. In addition, the intelligent transport device replaces human in transportation, which improves the transport efficiency while reducing labor costs.

A forming-machine equipment testing method disclosed by an embodiment of this application can be applied to a forming-machine equipment testing system. The forming-machine equipment testing system is used for, including but not limited to, calibration of electrical parameters of batteries.

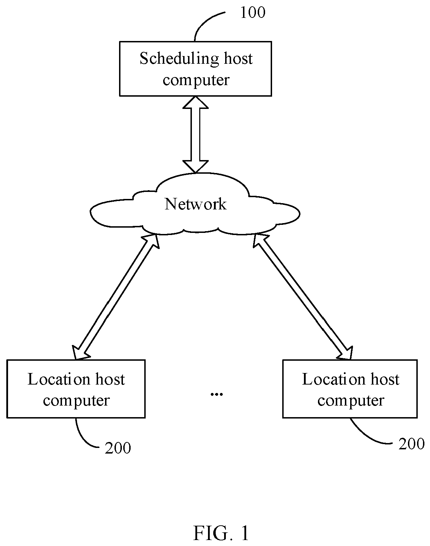

Referring to FIG. 1, FIG. 1 is a schematic diagram of a forming-machine equipment testing system according to some embodiments of this application. The forming-machine equipment testing system may include a scheduling host computer 100. Optionally, the system may further include, for example, a location host computer 200. The scheduling host computer 100 is in communication connection with one or more location host computers 200 via a network, for data communication or interaction. The scheduling host computer 100 may be a web server, a database server, a personal computer (PC), a tablet PC, a smartphone, a personal digital assistant (PDA), or the like. The location host computer 200 may be a web server, a database server, a personal computer (PC), a tablet computer, a smartphone, a personal digital assistant (PDA), or the like.

Optionally, the scheduling host computer 100 and the location host computer 200 may be two independent devices or two different parts integrated to one device. Disposition of the scheduling host computer 100 and the location host computer 200 can be selected based on actual situation, which is not specifically limited in this application.

A piece of equipment is scheduled by the scheduling host computer 100 to be transported to a corresponding target location, and the equipment is scheduled to be transported back to an original location after the equipment completes a test task. The location host computer 200 is used to deliver an obtained target test task of a piece of equipment to the corresponding equipment, so that the equipment executes the target test task.

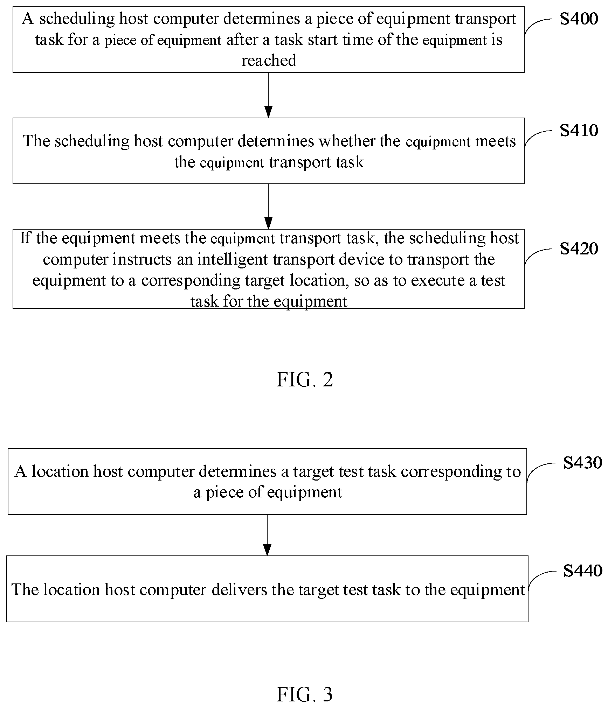

According to some embodiments of this application, a forming-machine equipment testing method can be applied to the foregoing forming-machine equipment testing system. As shown in FIG. 2, the forming-machine equipment testing method includes the following steps.

Step S400. A scheduling host computer determines an equipment transport task for the equipment after a task start time of the equipment is reached.

Step S410. The scheduling host computer determines whether the equipment meets the equipment transport task.

Step S420. If the equipment meets the equipment transport task, the scheduling host computer instructs an intelligent transport device to transport the equipment to a corresponding target location, so as to execute a test task for the equipment.

The scheduling host computer stores a task start time corresponding to each type of equipment.

In a possible implementation, the scheduling host computer further stores a corresponding task cycle time for each type of equipment. The task start time herein may be an initial task start time or a task start time upon arrival of a cycle of each task.

The task start time and task cycle corresponding to each type of equipment may be the same or different. The task start time and task cycle corresponding to each piece of equipment are determined based on specific work of the equipment, which is not specifically limited in this application.

In step S400, after a task start time of a piece of equipment is reached, the scheduling host computer determines a piece of equipment corresponding to the task start time based on the task start time and a prestored relationship between equipment and task start times, and generates, based on the equipment, an equipment transport task corresponding to the equipment.

After the equipment transport task is generated, it is ensured that the equipment can be successfully transported to the target location corresponding to the equipment. On this basis, whether the equipment meets the equipment transport task may also be determined before the equipment is transported. After the equipment meets the equipment transport task, the transport task is executed, so as to prevent unexpected transport. It should be understood that conditions corresponding to the equipment transport task to be met by the equipment may include a to-be-met transport status of the target location and a condition to be met by the equipment itself.

After determining that the equipment meets the equipment transport condition, the scheduling host computer delivers the equipment transport task to an intelligent transport device, so that the intelligent transport device transports the equipment from the original location to the target location and the equipment executes the corresponding test task in the target location.

In the foregoing process of implementation, the task start time of each piece of equipment is prestored in the scheduling host computer. Therefore, the scheduling host computer can be triggered to directly generate a corresponding equipment transport task after the task start time is reached. This realizes the purpose of periodic automatic testing, simplifies management of test tasks for equipment, and reduces errors in records and missed records for manual recording, thereby improving the testing accuracy of forming-machine equipment. In addition, before the intelligent transport device is controlled to transport the equipment, it is first determined whether the equipment meets the equipment transport task, and only when the equipment transport task is met, the intelligent transport device is controlled to transport the equipment to the corresponding target location. This reduces unexpected transport performed by the intelligent transport device and improves the testing efficiency of the forming-machine equipment.

According to some embodiments of this application, the forming-machine equipment testing system further includes the location host computer, as described above. As shown in FIG. 3, after the intelligent transport device transports the equipment to the corresponding target location, the method further includes the following steps.

Step S430. A location host computer determines a target test task corresponding to a piece of equipment.

Step S440. The location host computer delivers the target test task to the equipment.

Herein, one or more location host computers may be provided. If one location host computer is provided, the location host computer corresponds to all target locations. For example, the forming machine includes nine types of equipment and the nine types of equipment correspond to nine target locations. All the nine target locations correspond to the one location host computer.

If a plurality of location host computers are provided, in a possible implementation, each location host computer corresponds to one target location. In another possible implementation, each location host computer may alternatively correspond to a plurality of target locations. For another example, the forming machine includes nine types of equipment and the nine types of equipment correspond to nine target locations. Each of the nine target locations may correspond to one location host computer, that is, nine location host computers are provided. Alternatively, three location host computers may be provided, and each location host computer corresponds to three target locations.

The foregoing target test task includes a temperature test task or a pressure test task. Each type of equipment corresponds to one test task.

In step S430, in a possible implementation, a binding relationship between equipment and equipment types is stored in the location host computer. The location host computer determines an equipment type corresponding to the equipment based on obtained equipment information. The equipment information may be information for distinguishing equipment, such as an equipment image or an equipment identifier. The equipment image can be acquired by an image acquisition apparatus, and the image acquisition apparatus may be provided in a target location, at the place of the intelligent transport device, or the like. The image acquisition apparatus may be located based on the actual situation, which is not specifically limited in this application. The equipment identifier may be obtained from the scheduling host computer or the intelligent transport device. For example, when delivering an equipment transport task to the intelligent transport device, the scheduling host computer may also send equipment transport task information to the location host computer. The equipment transport task information includes an equipment identifier of the equipment. Alternatively, after transporting a piece of equipment to a target location, the intelligent transport device sends equipment information of the equipment to the location host computer. The equipment information includes an equipment identifier of the equipment and the like.

In another possible implementation, a binding relationship between equipment types and target locations is stored in the location host computer. The location host computer determines an equipment type corresponding to the equipment based on location information corresponding to the equipment. For example, a piece of equipment A1 corresponds to a target location A2. After obtaining information that the target location A2 is occupied, the location host computer determines that the equipment A1 needs to execute a test task, and then determines a corresponding equipment type based on the target location and determines a corresponding target test task based on the equipment type.

It can be understood that the foregoing implementation of step S430 is merely exemplary and does not constitute any limitation on step S430.

After determining the target test task, the location host computer delivers the target test task to the equipment transported to the target location. After receiving the target test task, the equipment in the target location executes the corresponding test task.

During the process of the foregoing implementations, after the equipment is transported to the target location, the location host computer automatically determines the target test task corresponding to the equipment and delivers it to the equipment. The entire process of generating a target test task can be completed automatically by the location host computer without human intervention, reducing labor costs.

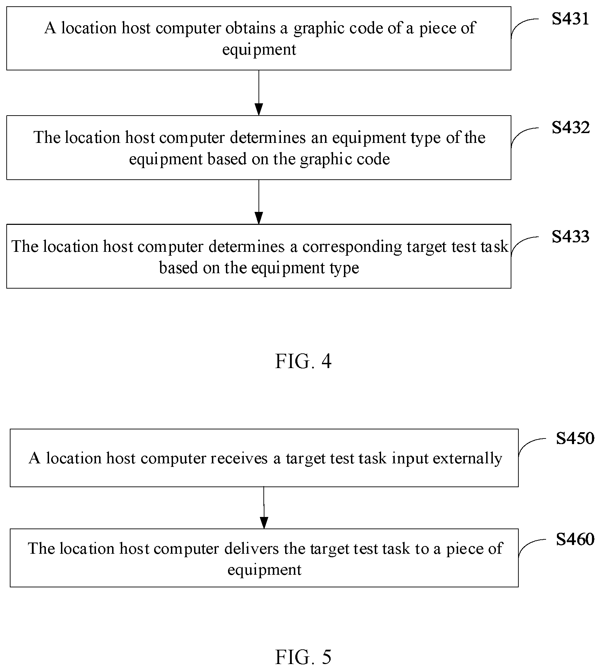

According to some embodiments of this application, as shown in FIG. 4, step S430 includes step S431 to step S433.

Step S431. The location host computer obtains a graphic code of the equipment.

Step S432. The location host computer determines an equipment type of the equipment based on the graphic code.

Step S433. The location host computer determines the corresponding target test task based on the equipment type.

Herein, each piece of equipment has a graphic code, and each piece of equipment corresponds to a unique graphic code, so as to determine the identifier of the equipment based on the graphic code. The graphic code includes, but is not limited to, a quick response code or a barcode.

In a possible implementation, in step S410, the scheduling host computer can determine an equipment type of a piece of equipment by obtaining the graphic code of the equipment, and determines, based on the equipment type, whether the equipment meets the equipment transport task. In this way, when the location host computer needs to determine a target test task, the location host computer can obtain the graphic code of the equipment from the scheduling host computer.

In another possible implementation, a scanning device may also be provided to scan the graphic code of the equipment and send the obtained graphic code to the location host computer.

It should be understood that in step S432, after obtaining the graphic code of the equipment, the location host computer determines the equipment type of the equipment based on the graphic code and a prestored binding relationship between equipment graphic codes and equipment types.

The location host computer prestores test tasks corresponding to each equipment type. After determining the equipment type, the location host computer further determines that a test task bound to the equipment type is the target test task.

During the process of the foregoing implementations, the equipment type is determined based on the graphic code of the equipment, and each piece of equipment corresponds to a unique graphic code. The unique equipment type can be determined based on the graphic code because a test task corresponding to each equipment type remains unchanged. Therefore, the equipment type is determined based on the graphic code and then the target test task is determined accordingly. This can greatly avoid risks caused by executing a wrong task by a piece of equipment, and improve the accuracy of task execution by the equipment.

According to some embodiments of this application, optionally, step S400 includes: the scheduling host computer receives a specified location input externally and determines the equipment transport task for the equipment based on the specified location.

As shown in FIG. 5, after the intelligent transport device transports the equipment to the corresponding target location, the method further includes the following steps.

Step S450. The location host computer receives a target test task input externally.

Step S460. The location host computer delivers the target test task to the equipment.

The external input may be a specified location and target test task that are selected manually through an interactive interface or an input and output device.

It can be understood that: in order to ensure the safety and accuracy of target locations, generally a target location is maintained when failed, or a target location is overhauled at the set time of overhaul to ensure that the target location is in a safe condition.

When a target location is under maintenance or overhaul but task start time is reached for a piece of equipment corresponding to the target location, another location can be manually specified as the location for the equipment to execute the test task. In addition, the specified location is input into the scheduling host computer. The scheduling host computer generates an equipment transport task based on the specified location and the equipment, and the intelligent transport device transports the equipment to the specified location. After the intelligent transport device transports the equipment to the specified location, a target test task corresponding to the equipment is determined manually, and the target test task to be executed by the equipment is input through the interactive interface or an input and output device.

In the case of external input, the specified location and the target test task are determined in a manual mode. In the manual mode, step S420 may be still performed in the automatic mode, or may be omitted so that step S430 is performed subsequent to step S410. In the manual mode, whether to perform S420 can be determined based on the actual situation, which is not specifically limited in this application.

The determining the target location based on the equipment by the scheduling host computer and determining the target test task by the location host computer are implemented in the automatic mode.

In a possible implementation, both the manual mode and automatic mode may be set for the forming-machine equipment testing method. If both the manual mode and automatic mode are set, an execution order of the two modes can be determined based on priorities. For example, the priority of the manual mode may be set to be higher than that of the automatic mode. In other words, the automatic mode does not work when the manual mode is activated.

In another possible implementation, both the manual mode and automatic mode may be set for the forming-machine equipment testing method. If both the manual mode and automatic mode are set, the manual mode can be activated at a set point of time (generally a fixed point of overhaul time for a target location), and the automatic mode is activated at all points of time points except that for the manual mode.

During the process of the foregoing implementations, when the target location corresponding to the equipment is under overhaul, the scheduling host computer is configured to determine a specified location according to information input externally, the location host computer is configured to obtain a target test task input externally, and the equipment is transported to the specified location for executing the target test task. Therefore, the test task for the equipment is completed manually. In this way, when the target location corresponding to the equipment is under overhaul, corresponding test tasks can be executed flexibly in another location, avoiding the case where a piece of equipment fails to execute a test task during overhaul of the target location and improving the flexibility of target test task execution by the forming-machine equipment.

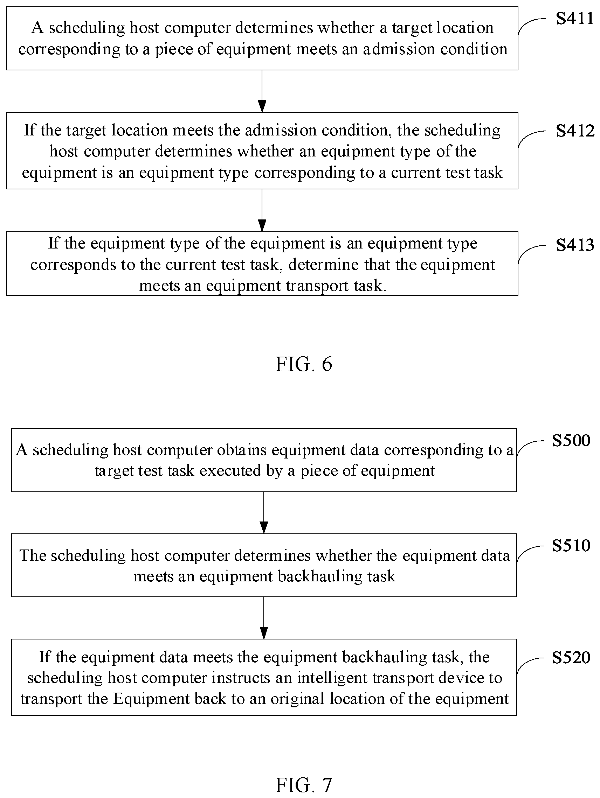

According to some embodiments of this application, as shown in FIG. 6, step S410 includes step S411 to step S413.

Step S411. The scheduling host computer determines whether the target location corresponding to the equipment meets an admission condition.

Step S412. If the target location meets the admission condition, the scheduling host computer determines whether an equipment type of the equipment is an equipment type corresponding to a current test task.

Step S413. If the equipment type of the equipment is an equipment type corresponds to the current test task, determine that the equipment meets the equipment transport task.

A transport status of the target location to be met may be that a previous test task is completed in the target location or the target location is in an unoccupied state. In a possible implementation, after the equipment completes a test task in the target location, equipment data is uploaded to the scheduling host computer. Then, the scheduling host computer directly determines, based on the equipment data, whether the previous test task is completed in the target location. In another possible implementation, a status of the target location may be obtained by a sensor or an image acquisition apparatus. The sensor may be an optical sensor, a pressure sensor, or the like, so that the status of the target location can be determined based on an optical signal or a pressure signal of the target location. The image acquisition apparatus may be a scanner, a camera, a video camera, or the like, so as to determine, based on image information of the target location, whether the target location is occupied.

In some embodiments, after step S411, the scheduling host computer may further determine whether the equipment itself meets a transport condition.

In a possible implementation, the condition to be met by the equipment itself may be that the equipment is in an unoccupied state. The status of the equipment may be obtained in the following manner.

For example, after the equipment completes a test task in the target location, equipment data is uploaded to the scheduling host computer. Then, the scheduling host computer directly determines, based on the equipment data, whether the previous test task is completed in the target location, so as to determine the status of the equipment.

For another example, the status of the equipment is obtained by a sensor or an image acquisition apparatus provided in an original location of the equipment. The sensor may be an optical sensor, a pressure sensor, or the like, so that the status of the equipment can be determined based on an optical signal or a pressure signal of the original location. The image acquisition apparatus may be a scanner, a camera, a video camera, or the like, so that the status of the equipment is determined based on image information of the equipment.

In another possible implementation, the condition to be met by the equipment itself may be that the equipment is of the equipment type corresponding to the current test task.

For example, in step S412, the scheduling host computer stores a binding relationship between equipment and equipment types. The scheduling host computer determines an equipment type corresponding to the equipment based on obtained equipment information. The equipment information may be an equipment image, and the equipment image can be acquired by an image acquisition apparatus. The image acquisition apparatus may be provided in an original location of the equipment, at the place of the intelligent transport device, or the like. The image acquisition apparatus may be provided based on actual situation, which is not specifically limited in this application.

The equipment information may also be an equipment graphic code, and the equipment graphic code corresponds to a unique equipment identifier. The equipment graphic code herein can be obtained by using a scanning device. After obtaining the equipment graphic code, the scanning device sends the equipment graphic code to the scheduling host computer, so that the scheduling host computer determines an equipment type corresponding to the equipment based on the equipment identifier in the graphic code.

The equipment type corresponding to the current test task may be determined based on a current point of time or a to-be-tested parameter of the current test task in the scheduling host computer or the location host computer. Determining of the equipment type corresponding to the current test task can be adjusted based on the actual situation, which is not specifically limited in this application.

It can be understood that the foregoing implementation of step S412 is merely exemplary, and does not constitute any limitation on step S412.

During the process of the foregoing implementations, whether the target location meets the admission condition and whether the equipment type is the equipment type corresponding to the current test task are determined separately. The equipment transport task is determined only when the target location meets the admission condition and the equipment type is the equipment type corresponding to the current test task. This prevents the intelligent transport device from performing unexpected transport in case of the equipment being inconsistent with the equipment type corresponding to the current test task and the target location being occupied, and improves the execution efficiency and accuracy of equipment transport tasks.

According to some embodiments of this application, step S412 includes: the scheduling host computer obtains a graphic code of the equipment and determines the equipment type of the equipment based on the graphic code, so as to determine whether the equipment type of the equipment is an equipment type corresponds to the current test task.

The foregoing forming-machine equipment is provided with a unique corresponding graphic code, so that an equipment identifier and an equipment type corresponding to each piece of equipment can be determined based on the graphic code.

The scheduling host computer herein may obtain the graphic code of the equipment through a scanning device or may obtain the graphic code of the equipment through an image acquisition device. In a possible implementation, the scanning device or the image acquisition device herein can be provided in an original location of the equipment. In another possible implementation, an equipment scanning location may also be provided. The scanning device or the image acquisition device is provided in the equipment scanning location. It should be understood that after it is determined that a target location meets an admission condition, the intelligent transport device can transport the equipment to the equipment scanning location, so as to obtain the graphic code of the equipment at the equipment scanning location.

After obtaining the graphic code of the equipment, the scheduling host computer can determine an equipment type of the equipment based on the graphic code of the equipment and a binding relationship between graphic codes and equipment types that is prestored in the scheduling host computer.

During the process of the foregoing implementations, the graphic code of the equipment is obtained, and equipment type verification is performed on the to-be-transported equipment based on the binding relationship between graphic codes and equipment types, so as to determine that the to-be-transported equipment is of the equipment type corresponding to the current test task. In this way, a piece of equipment will not be transported by wrong, improving the accuracy of transport tasks.

According to some embodiments of this application, as shown in FIG. 7, after the target test task is executed in the target location, the method further includes the following steps.

Step S500. The scheduling host computer obtains equipment data corresponding to the target test task executed by the equipment.

Step S510. The scheduling host computer determines whether the equipment data meets an equipment backhauling task.

Step S520. If the equipment data meets the equipment backhauling task, the scheduling host computer instructs the intelligent transport device to transport the equipment back to an original location of the equipment.

In a possible implementation, in step S500, after completing a target test task, each piece of equipment uploads, to the scheduling host computer, the equipment data for the target test task executed by the equipment, so that the scheduling host computer obtains the equipment data corresponding to the target test task executed by the equipment. In another possible implementation, in step S500, the scheduling host computer may obtain equipment data of each piece of equipment at preset intervals, including the equipment data corresponding to the target test task executed by the equipment.

After the scheduling host computer obtains the equipment data corresponding to the target test task executed by the equipment, the scheduling host computer can further determine, based on the equipment data of the equipment, whether the equipment meets the equipment backhauling task. The equipment meeting the equipment backhauling task may include that the original location of the equipment is unoccupied, the equipment has completed the target test task, and so on. The manner of determining whether the original location is occupied is the same as that of determining whether the target location is occupied, and details are not described herein again. Whether the equipment has completed the target test task can be determined based on the equipment data. The equipment data includes the time when the equipment executes the test task. Specifically, whether the equipment executes a test task after execution of the latest equipment transport task is determined, so as to determine whether the equipment has completed the target test task.

It can be understood that if the equipment data does not meet the equipment backhauling task, alarm information is generated accordingly for manual judgment.

In some embodiments, the equipment uploads to the scheduling host computer the equipment data on execution of the target test task, where the equipment data is uploaded using preset fields.

It can be understood that the scheduling host computer provides a preset storage format for storing the equipment data. For example, in the storage format, equipment task number, equipment pallet number, location number, status, and the like may be arranged sequentially from left to right. In this way, the equipment data can be uploaded according to the foregoing fields. Certainly, the foregoing fields may further include equipment type, task start time, task end time, upload result, and the like.

In a possible implementation, after the equipment data is uploaded by the equipment, the equipment data of each piece of equipment can be queried on the scheduling host computer and displayed on a display apparatus. The equipment data can be displayed in a set storage format. As shown in the foregoing example of storage, the equipment data may include equipment task number, equipment pallet number, location number, status, and the like, which are displayed sequentially from left to right.

During the process of the foregoing implementations, after the equipment completes the target test task, the scheduling host computer obtains the equipment data for the target test task executed by the equipment. On the one hand, after obtaining the equipment data, the scheduling host computer can automatically record data such as execution time, content, and the equipment type for the target test task executed by the equipment to form a systematic record of use. This facilitates automatic management of equipment, locations, and the like, and simplifies management of equipment and locations for the forming machine. On the other hand, whether the equipment meets the equipment backhauling task is determined based on the equipment data, and when the equipment meets the transport task, the intelligent transport device is instructed to transport the equipment back to the original location, so as to periodically schedule each piece of equipment to execute corresponding test tasks. This allows the forming-machine equipment to execute test tasks automatically, reducing human intervention and labor costs while improving the test task execution efficiency of the forming-machine equipment.

According to some embodiments of this application, an embodiment of this application provides a forming-machine equipment testing system. It can be understood that the system corresponds to the method embodiments implemented in FIG. 2 to FIG. 7, and can implement the steps in the foregoing method. For specific functions of the system, refer to the foregoing description. To avoid repetition, detailed description is appropriately omitted. The system includes a scheduling host computer 100. The scheduling host computer 100 is configured to: determine an equipment transport task for the equipment after a task start time of the equipment is reached; determine whether the equipment meets the equipment transport task; and if the equipment meets the equipment transport task, instruct an intelligent transport device to transport the equipment to a corresponding target location, so that the equipment is controlled to execute a test task in a target location.

As an embodiment, the forming-machine equipment testing system may further include an intelligent transport device. The intelligent transport device is in communication connection with the scheduling host computer 100 and/or a location host computer 200 via a network, for data communication or interaction. The intelligent transport device may be an RGV (Rail Guided Vehicle), an AGV trolley, a robot, a robot arm, or the like.

The intelligent transport device is used to transport a piece of equipment from an original location to a corresponding target location after obtaining a transport command. Moreover, the intelligent transport device transports the equipment back to the original location after the equipment has completed a task in the target location.

In the foregoing process of implementation, the task start time of each piece of equipment is prestored in the scheduling host computer. Therefore, the scheduling host computer can be triggered to directly generate a corresponding equipment transport task after the task start time is reached. This realizes the purpose of periodic automatic testing, simplifies management of test tasks for equipment, and reduces errors in records and missed records for manual recording, thereby improving the testing accuracy of forming-machine equipment. In addition, before the intelligent transport device is controlled to transport the equipment, it is first determined whether the equipment meets the equipment transport task, and only when the equipment transport task is met, the intelligent transport device is controlled to transport the equipment to the corresponding target location. This reduces unexpected transport performed by the intelligent transport device and improves the testing efficiency of the forming-machine equipment.

In a possible implementation, the system further includes a location host computer 200. The location host computer is configured to: after the intelligent transport device transports the equipment to the corresponding target location, determine a target test task corresponding to the equipment and deliver the target test task to the equipment.

In a possible implementation, the location host computer 200 is further configured to: obtain a graphic code of the equipment and determine an equipment type of the equipment based on the graphic code; and determine the corresponding target test task based on the equipment type.

In a possible implementation, the system further includes a location host computer 200, configured to: after the intelligent transport device transports the equipment to the corresponding target location, receive a target test task input externally and deliver the target test task to the equipment.

In a possible implementation, the scheduling host computer 100 is further configured to determine whether the target location corresponding to the equipment meets an admission condition. The scheduling host computer 100 is further configured to: if the target location meets the admission condition, determine whether an equipment type of the equipment is an equipment type corresponding to a current test task; and if the equipment type of the equipment is an equipment type corresponds to the current test task, determine that the equipment meets the equipment transport task.

In a possible implementation, the scheduling host computer 100 is further configured to obtain a graphic code of the equipment and determine the equipment type of the equipment based on the graphic code, so as to determine whether the equipment type of the equipment is an equipment type corresponds to the current test task.

In a possible implementation, after the target test task is executed at the target location, the scheduling host computer 100 is further configured to: obtain the equipment data corresponding to the execution of the target test task by the equipment; determine whether the equipment data meets the equipment backhauling task; and if the equipment data meets the equipment backhauling task, instruct the intelligent handling device to transport the equipment back to the original location of the equipment.

As an embodiment, the forming-machine equipment testing system may further include a scanning device. The scanning device is in communication connection with the scheduling host computer 100 and/or the location host computer 200 via a network, for data communication or interaction. The scanning device may be a scanner, a camera, a video camera, a scanner gun, or the like.

The scanning device is used to obtain a graphic code of the equipment, so as to determine an equipment type of the equipment based on the graphic code.

It can be understood that the scheduling host computer 100 and the location host computer 200 both store a binding relationship between graphic codes of equipment and equipment types. The scanning device can send the acquired graphic code to the scheduling host computer 100 and/or the location host computer 200, so that the scheduling host computer 100 and/or the location host computer 200 determine an equipment type corresponding to the equipment.

In some embodiments, the intelligent transport device may first transport the equipment to the location of the scanning device after obtaining a transport command. In the location of the scanning device, the scanning device obtains the graphic code of the equipment, sends the graphic code to the scheduling host computer 100, and verifies the equipment type of the equipment through the scheduling host computer 100.

Optionally, the scanning device and the intelligent transport device may be part of the forming-machine equipment testing system or may be device independent of the forming-machine equipment testing system. Disposition of the scanning device and intelligent transport device may be adjusted based on the actual situation, which is not specifically limited in this application.

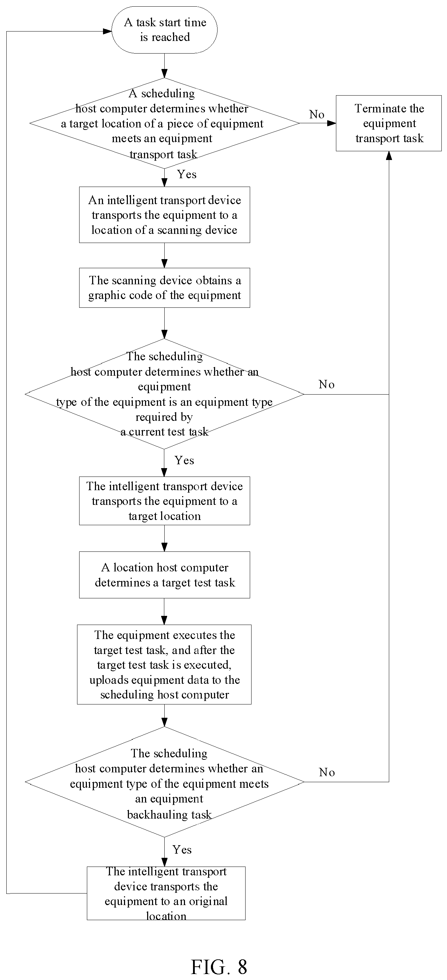

As shown in FIG. 8, FIG. 8 is a schematic flowchart of an interaction between various devices in a forming-machine equipment testing system. The forming-machine equipment testing system controls a piece of equipment to execute a test task. The scheduling host computer 100 stores a task start time corresponding to each type of equipment. When task start time is reached, the scheduling host computer 100 determines a corresponding piece of equipment based on the task start time, and determines, based on the equipment, whether a target location corresponding to the equipment meets the equipment transport task.

The equipment transport task is generated when the target location meets the equipment transport task, and the equipment transport task is sent to the intelligent transport device. After receiving the equipment transport task, the intelligent transport device transports the equipment to the location of the scanning device. The scanning device scans the graphic code on the equipment and sends the graphic code to the scheduling host computer 100. The scheduling host computer 100 determines the equipment type corresponding to the equipment based on the graphic code and a prestored binding relationship between graphic codes and equipment types, and determines whether the equipment type is the equipment type required by the current test task. When the equipment is of an equipment type required by the current test task, the intelligent transport device transports the equipment from the location of the scanning device to the target location.

When the equipment is transported to the target location, the location host computer 200 obtains the graphic code of the equipment from the scheduling host computer 100 or the scanning device, determines the target test task corresponding to the target location based on the graphic code and the prestored binding relationship between graphic codes and equipment types, and delivers the target test task to the equipment so that the target test task is executed by the equipment.

After the equipment executes the target test task, the equipment sends equipment data on execution of the target test task to the scheduling host computer 100. After obtaining the equipment data, the scheduling host computer 100 determines whether the equipment meets an equipment backhauling task based on the equipment data. When the equipment meets the equipment backhauling task, the intelligent transport device is instructed to transport the equipment back to the original location of the equipment.

For ease of understanding of this embodiment, the following describes in detail an electronic device used to execute a forming-machine equipment testing method disclosed by the embodiment of this application.

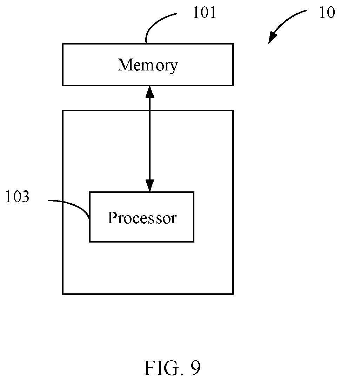

As shown in FIG. 9, FIG. 9 is a block diagram of the electronic device. An electronic device 10 may include a memory 101 and a processor 103. A person of ordinary skill in the art may understand that the structure illustrated in FIG. 9 is merely exemplary and does not limit the structure of the electronic device 10. For example, the electronic device 10 may further include more or fewer components than shown in FIG. 9, or have a different configuration from as shown in FIG. 9.

The memory 101 and the processor 103 are in direct or indirect electric connection to implement data transmission or interaction. For example, these components may be electrically connected to each other via one or more communication buses or signal cables. The processor 103 is used to execute executable modules stored in the memory.

The memory 101 may be, but is not limited to, a random access memory (RAM), a read only memory (ROM), a programmable read-only memory (PROM), an erasable programmable read-only memory (EPROM), an electric erasable programmable read-only memory (EEPROM), and the like. The memory 101 is used to store a program. The processor 103 executes the program upon receiving an execution instruction. The method executed by the electronic device 10 as defined by the process disclosed in any one of the embodiments of this application may be applied to the processor 103 or implemented by the processor 103.

The processor 103 may be an integrated circuit chip with a signal processing capability. The processor 103 may be a general-purpose processor, including a central processing unit (CPU), a network processor (NP), and the like; or may be a digital signal processor (DSP), an application specific integrated circuit (ASIC), a field programmable gate array (FPGA) or another programmable logic device, a discrete gate or transistor logic device, or a discrete hardware component. The methods, steps, and logic block diagrams disclosed in the embodiments of this application can be implemented or performed. The general-purpose processor may be a microprocessor, or the processor may be any conventional processor or the like.

The electronic device 10 in this embodiment can be used to perform various steps in the various methods provided in the embodiments of this application.

This application provides a computer-readable storage medium, and the computer-readable storage medium stores a computer program. When the computer program is executed by a processor, the method in any one of the foregoing optional implementations is implemented.

The storage medium may be implemented by any type of volatile or nonvolatile storage device or a combination thereof, such as a static random access memory (), an electrically erasable programmable read-only memory (EEPROM), an erasable programmable read only memory (EPROM), a programmable read-only memory (PROM), a read-only memory (ROM), a magnetic memory, a flash memory, a magnetic disk, or a compact disc.

This application provides a computer program product. When the computer program product runs on a computer, the method in any one of the optional implementations is implemented by the computer.

In the several embodiments provided in this application, it should be understood that the disclosed apparatus and method may be implemented in other manners. The apparatus embodiment described above is merely illustrative, for example, the flowcharts and block diagrams in the drawings illustrate probably implemented system architectures, functions and operations of the apparatus, method, and computer program product according to a plurality of embodiments of this application. In this regard, each block in the flowcharts or the block diagrams may represent part of a module, a program segment or code, and part of the module, the program segment or the code includes one or more executable instructions configured to realize a specified logical function. It should be also noted that in some alternative implementations, the functions marked in the blocks may also be realized in a sequence different from those marked in the accompanying drawings. For example, two continuous blocks may actually be executed substantially concurrently and may also be executed in a reverse sequence sometimes, which is determined by the involved functions. It is further to be noted that each block in the block diagrams and/or the flowcharts and a combination of the blocks in the block diagrams and/or the flowcharts may be implemented by a dedicated hardware-based system configured to execute a specified function or operation or may be implemented by a combination of a special hardware and a computer instruction.

In addition, each functional module in each embodiment of the application may be integrated into an independent part, each module may also independently exist, and two or more than two modules may also be integrated into an independent part.

When realized in form of software functional module and sold or used as an independent product, the function may also be stored in a computer-readable storage medium. Based on such an understanding, the technical solutions of the application substantially or parts making contributions to the conventional art or part of the technical solutions may be embodied in form of software product, and the computer software product is stored in a storage medium, including a plurality of instructions configured to enable a computer device (which may be a personal computer, a server, a network device or the like) to execute all or part of the steps of the method in each embodiment of the application. The foregoing storage medium includes various media capable of storing program codes such as a U disk, a mobile hard disk, a read-only memory (ROM), a random access memory (RAM), a magnetic disk, or an optical disk. It should be noted that relational terms such as "first" and "second" are only adopted to distinguish one entity or operation from another entity or operation, and are not necessarily required or implied that there is any such actual relationship or order between these entities or operations. Terms "comprise", "include", or any other variations thereof are intended to cover non-exclusive inclusions, such that a process, method, article or device including a series of elements not only includes these elements, but also includes other elements which are not expressly listed, or further includes elements which are inherent to such process, method, article or device. Under the condition of no more limitations, an element defined by the statement "including one..." does not exclude existence of the same other elements in a process, a method, an article or a device including the element.

The foregoing descriptions are merely preferred embodiments of this application, but are not intended to limit this application. Persons skilled in the art understand that this application may have various modifications and variations. It should be noted that similar reference numerals and letters indicate similar items in the following drawings, and therefore once an item is defined in one drawing, it does not need to be further defined or explained in the subsequent drawings.

The foregoing descriptions are merely specific embodiments of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A forming-machine equipment testing method, carried out by a forming-machine equipment testing system, wherein the forming-machine equipment testing system comprises a scheduling host computer, and the scheduling host computer stores a task start time corresponding to each type of equipment; and
the method comprises:
determining (S400), by the scheduling host computer, an equipment transport task for the equipment after a task start time of the equipment is reached;
determining (S410), by the scheduling host computer, whether the equipment meets the equipment transport task; and
if the equipment meets the equipment transport task, instructing (S420), by scheduling host computer, an intelligent transport device to transport the equipment to a corresponding target location, so as to execute a test task for the equipment, wherein the test task comprises a temperature test task or a pressure test task;
wherein the forming-machine equipment testing system further comprises a location host computer, and the method further comprises:
after the intelligent transport device transports the equipment to the corresponding target location, determining (S430), by the location host computer, a target test task corresponding to the equipment and delivering (S440) the target test task to the equipment;
wherein the determining (S430), by the location host computer, a target test task corresponding to the equipment comprises:
obtaining (S431), by the location host computer, a graphic code of the equipment, and determining (S432) an equipment type of the equipment based on the graphic code; and
determining (S433), by the location host computer, the corresponding target test task based on the equipment type.

2. The method according to claim 1, wherein the determining (S400), by the scheduling host computer, an equipment transport task for the equipment comprises:
receiving, by the scheduling host computer, a specified location input externally and determining the equipment transport task for the equipment based on the specified location; and
the method further comprises:
after the intelligent transport device transports the equipment to the specified location, receiving (S450), by the location host computer, a target test task input externally and delivering (S460) the target test task to the equipment.

3. The method according to claim 1, wherein the determining (S410), by the scheduling host computer, whether the equipment meets the equipment transport task comprises:
determining (S411), by the scheduling host computer, whether the target location corresponding to the equipment meets an admission condition;
if the target location meets the admission condition, determining (S412), by the scheduling host computer, whether an equipment type of the equipment is an equipment type corresponding to a current test task; and
if the equipment type of the equipment is an equipment type corresponds to the current test task, determining (S413) that the equipment meets the equipment transport task.

4. The method according to claim 3, wherein the determining (S412), by the scheduling host computer, whether an equipment type of the equipment is an equipment type corresponding to a current test task comprises:
obtaining, by the scheduling host computer, the graphic code of the equipment and determining the equipment type of the equipment based on the graphic code, so as to determine whether the equipment type of the equipment is an equipment type corresponds to the current test task.

5. The method according to any one of claims 1 to 4, wherein the method further comprises:
after the target test task is executed in the target location, obtaining (S500), by the scheduling host computer, equipment data corresponding to the target test task executed by the equipment;
determining (S510), by the scheduling host computer, whether the equipment data meets an equipment backhauling task; and
if the equipment data meets the equipment backhauling task, instructing (S520), by the scheduling host computer, the intelligent transport device to transport the equipment back to an original location of the equipment.

6. A system for executing a forming-machine equipment task, comprising a scheduling host computer (100), wherein the scheduling host computer (100) stores a task start time corresponding to each type of equipment; and
the scheduling host computer (100) is configured to: determine an equipment transport task for the equipment after a task start time of the equipment is reached;
determine whether the equipment meets the equipment transport task; and
if the equipment meets the equipment transport task, instruct an intelligent transport device to transport the equipment to a corresponding target location, so as to execute a test task for the equipment, wherein the test task comprises a temperature test task or a pressure test task;
wherein the system further comprises a location host computer (200) configured to: after the intelligent transport device transports the equipment to the corresponding target location, determine a target test task corresponding to the equipment and deliver the target test task to the equipment; and
wherein the location host computer (200) is further configured to:
obtain a graphic code of the equipment and determine an equipment type of the equipment based on the graphic code; and
determine the corresponding target test task based on the equipment type.

7. The system according to claim 6, wherein the location host computer (200) is configured to: after the intelligent transport device transports the equipment to the corresponding target location, receive a target test task input externally and deliver the target test task to the equipment.

8. The system according to claim 6, wherein:
the scheduling host computer (100) is further configured to determine whether the target location corresponding to the equipment meets an admission condition;
the scheduling host computer (100) is further configured to: if the target location meets the admission condition, determine whether an equipment type of the equipment is an equipment type corresponding to a current test task; and
if the equipment type of the equipment is an equipment type corresponds to the current test task, determining that the equipment meets the equipment transport task.

9. The system according to claim 6, wherein:
the scheduling host computer (100) is further configured to obtain the graphic code of the equipment and determine the equipment type of the equipment based on the graphic code, so as to determine whether the equipment type of the equipment is an equipment type corresponds to the current test task.

10. The system according to any one of claims 6 to 9, wherein:
after the target test task is executed in the target location, the scheduling host computer (100) is further configured to: obtain equipment data corresponding to the target test task executed by the equipment;
determine whether the equipment data meets an equipment backhauling task; and
if the equipment data meets the equipment backhauling task, instruct the intelligent transport device to transport the equipment back to an original location of the equipment.

11. A computer-readable storage medium, storing a computer program, wherein when the computer program is executed by a processor (103), the method according to any one of claims 1 to 5 is implemented.

## Patentansprüche

1. Testverfahren für Ausrüstung von Formierungsmaschinen, ausgeführt durch ein Testsystem für Ausrüstung von Formierungsmaschinen, wobei das Testsystem für Ausrüstung von Formierungsmaschinen einen ablaufsteuernden Hostcomputer umfasst und der ablaufsteuernde Hostcomputer eine Task-Startzeit entsprechend jedem Typ von Ausrüstung speichert; und
wobei das Verfahren Folgendes umfasst:
Bestimmen (S400), durch den ablaufsteuernden Hostcomputer, einer Ausrüstungstransporttask für die Ausrüstung, nachdem eine Task-Startzeit der Ausrüstung erreicht ist;
Bestimmen (S410), durch den ablaufsteuernden Hostcomputer, ob die Ausrüstung der Ausrüstungstransporttask genügt; und
wenn die Ausrüstung der Ausrüstungstransporttask genügt, Instruieren (S420), durch den ablaufsteuernden Hostcomputer, einer intelligenten Transportvorrichtung, die Ausrüstung zu einem entsprechenden Zielort zu transportieren, um eine Testtask für die Ausrüstung auszuführen, wobei die Testtask eine Temperaturtesttask oder eine Drucktesttask umfasst;
wobei das Testsystem für Ausrüstung von Formierungsmaschinen ferner einen Standorthostcomputer umfasst und das Verfahren ferner Folgendes umfasst:
nachdem die intelligente Transportvorrichtung die Ausrüstung zum entsprechenden Zielort transportiert hat, Bestimmen (S430), durch den Standorthostcomputer, einer der Ausrüstung entsprechenden Zieltesttask und Liefern (S440) der Zieltesttask an die Ausrüstung;
wobei das Bestimmen (S430), durch den Standorthostcomputer, einer der Ausrüstung entsprechenden Zieltesttask Folgendes umfasst:
Beschaffen (S431), durch den Standorthostcomputer, eines grafischen Codes der Ausrüstung und Bestimmen (S432) eines Ausrüstungstyps der Ausrüstung auf der Basis des grafischen Codes; und
Bestimmen (S433), durch den Standorthostcomputer, der entsprechenden Zieltesttask auf der Basis des Ausrüstungstyps.

2. Verfahren nach Anspruch 1, wobei das Bestimmen (S400), durch den ablaufsteuernden Hostcomputer, einer Ausrüstungstransporttask für die Ausrüstung Folgendes umfasst:
Empfangen, durch den ablaufsteuernden Hostcomputer, eines extern eingegebenen spezifizierten Standorts und Bestimmen der Ausrüstungstransporttask für die Ausrüstung auf der Basis des spezifizierten Standorts; und
das Verfahren ferner Folgendes umfasst:
nachdem die intelligente Transportvorrichtung die Ausrüstung zum spezifizierten Standort transportiert hat, Empfangen (S450), durch den Standorthostcomputer, einer extern eingegebenen Zieltesttask und Liefern (S460) der Zieltesttask an die Ausrüstung.

3. Verfahren nach Anspruch 1, wobei das Bestimmen (S410), durch den ablaufsteuernden Hostcomputer, ob die Ausrüstung der Ausrüstungstransporttask genügt, Folgendes umfasst:
Bestimmen (S411), durch den ablaufsteuernden Hostcomputer, ob der der Ausrüstung entsprechende Zielort einer Einlassbedingung genügt;
wenn der Zielort der Einlassbedingung genügt, Bestimmen (S412), durch den ablaufsteuernden Hostcomputer, ob ein Ausrüstungstyp der Ausrüstung ein einer aktuellen Testtask entsprechender Ausrüstungstyp ist; und
wenn der Ausrüstungstyp der Ausrüstung ein der aktuellen Testtask entsprechender Ausrüstungstyp ist, Bestimmen (S413), dass die Ausrüstung der Ausrüstungstransporttask genügt.

4. Verfahren nach Anspruch 3, wobei das Bestimmen (S412), durch den ablaufsteuernden Hostcomputer, ob ein Ausrüstungstyp der Ausrüstung ein einer aktuellen Testtask entsprechender Ausrüstungstyp ist, Folgendes umfasst:
Beschaffen, durch den ablaufsteuernden Hostcomputer, des grafischen Codes der Ausrüstung und Bestimmen des Ausrüstungstyps der Ausrüstung auf der Basis des grafischen Codes, um zu bestimmen, ob der Ausrüstungstyp der Ausrüstung ein der aktuellen Testtask entsprechender Ausrüstungstyp ist.

5. Verfahren nach einem der Ansprüche 1 bis 4, wobei das Verfahren ferner Folgendes umfasst:
nachdem die Zieltesttask am Zielort ausgeführt ist, Beschaffen (S500), durch den ablaufsteuernden Hostcomputer, von Ausrüstungsdaten entsprechend der von der Ausrüstung ausgeführten Zieltesttask;
Bestimmen (S510), durch den ablaufsteuernden Hostcomputer, ob die Ausrüstungsdaten einer Ausrüstungsrückholtask genügen; und
wenn die Ausrüstungsdaten der Ausrüstungsrückholtask genügen, Instruieren (S520), durch den ablaufsteuernden Hostcomputer, der intelligenten Transportvorrichtung, die Ausrüstung zurück zu einem originalen Standort der Ausrüstung zu transportieren.

6. System zum Ausführen einer Ausrüstungstask für Formierungsmaschinen, umfassend einen ablaufsteuernden Hostcomputer (100), wobei der ablaufsteuernde Hostcomputer (100) eine Task-Startzeit entsprechend jedem Typ von Ausrüstung speichert; und
der ablaufsteuernde Hostcomputer (100) zu Folgendem konfiguriert ist: Bestimmen einer Ausrüstungstransporttask für die Ausrüstung, nachdem eine Task-Startzeit der Ausrüstung erreicht ist;
Bestimmen, ob die Ausrüstung der Ausrüstungstransporttask genügt; und
wenn die Ausrüstung der Ausrüstungstransporttask genügt, Instruieren einer intelligenten Transportvorrichtung, die Ausrüstung zu einem entsprechenden Zielort zu transportieren, um eine Testtask für die Ausrüstung auszuführen, wobei die Testtask eine Temperaturtesttask oder eine Drucktesttask umfasst;
wobei das System ferner einen Standorthostcomputer (200) umfasst, der zu Folgendem konfiguriert ist: nachdem die intelligente Transportvorrichtung die Ausrüstung zum entsprechenden Zielort transportiert hat, Bestimmen einer der Ausrüstung entsprechenden Zieltesttask und Liefern der Zieltesttask an die Ausrüstung; und
wobei der Standorthostcomputer (200) ferner zu Folgendem konfiguriert ist:
Beschaffen eines grafischen Codes der Ausrüstung und Bestimmen eines Ausrüstungstyps der Ausrüstung auf der Basis des grafischen Codes; und
Bestimmen der entsprechenden Zieltesttask auf der Basis des Ausrüstungstyps.

7. System nach Anspruch 6, wobei der Standorthostcomputer (200) zu Folgendem konfiguriert ist: nachdem die intelligente Transportvorrichtung die Ausrüstung zum entsprechenden Zielort transportiert hat, Empfangen einer extern eingegebenen Zieltesttask und Liefern der Zieltesttask an die Ausrüstung.

8. System nach Anspruch 6, wobei:
der ablaufsteuernde Hostcomputer (100) ferner konfiguriert ist zu bestimmen, ob der der Ausrüstung entsprechende Zielort einer Einlassbedingung genügt;
der ablaufsteuernde Hostcomputer (100) ferner zu Folgendem konfiguriert ist: wenn der Zielort der Einlassbedingung genügt, Bestimmen, ob ein Ausrüstungstyp der Ausrüstung ein einer aktuellen Testtask entsprechender Ausrüstungstyp ist; und
wenn der Ausrüstungstyp der Ausrüstung ein der aktuellen Testtask entsprechender Ausrüstungstyp ist, Bestimmen, dass die Ausrüstung der Ausrüstungstransporttask genügt.

9. System nach Anspruch 6, wobei:
der ablaufsteuernde Hostcomputer (100) ferner zum Beschaffen des grafischen Codes der Ausrüstung und Bestimmen des Ausrüstungstyps der Ausrüstung auf der Basis des grafischen Codes konfiguriert ist, um zu bestimmen, ob der Ausrüstungstyp der Ausrüstung ein der aktuellen Testtask entsprechender Ausrüstungstyp ist.

10. System nach einem der Ansprüche 6 bis 9, wobei:
nachdem die Zieltesttask am Zielort ausgeführt ist, der ablaufsteuernde Hostcomputer (100) ferner zu Folgendem konfiguriert ist: Beschaffen von Ausrüstungsdaten entsprechend der von der Ausrüstung ausgeführten Zieltesttask;
Bestimmen, ob die Ausrüstungsdaten einer Ausrüstungsrückholtask genügen; und
wenn die Ausrüstungsdaten der Ausrüstungsrückholtask genügen, Instruieren der intelligenten Transportvorrichtung, die Ausrüstung zurück zu einem originalen Standort der Ausrüstung zu transportieren.

11. Computerlesbares Speichermedium mit einem darauf gespeicherten Computerprogramm, wobei bei Ausführung des Computerprogramms durch einen Prozessor (103) das Verfahren nach einem der Ansprüche 1 bis 5 implementiert wird.

## Revendications

1. Procédé de test d'équipement pour machine de fabrication, mis en œuvre par un système de test d'équipement pour machine de fabrication, le système de test d'équipement pour machine de fabrication comprenant un ordinateur hôte de planification, et l'ordinateur hôte de planification stockant une heure de début de tâche correspondant à chaque type d'équipement ; et
le procédé comprenant les étapes consistant à :
déterminer (S400), par l'ordinateur hôte de planification, une tâche de transport d'équipement pour l'équipement après que l'heure de début de tâche de l'équipement a été atteinte ;
déterminer (S410), par l'ordinateur hôte de planification, si l'équipement satisfait à la tâche de transport d'équipement ; et
si l'équipement satisfait à la tâche de transport d'équipement, donner l'instruction (S420), par l'ordinateur hôte de planification, à un dispositif de transport intelligent de transporter l'équipement vers une localisation cible correspondante, de manière à exécuter une tâche de test pour l'équipement, la tâche de test comprenant une tâche de test de température ou une tâche de test de pression ;
le système de test d'équipement pour machine de fabrication comprenant en outre un ordinateur hôte de localisation, et le procédé comprenant en outre les étapes consistant à :
après que le dispositif de transport intelligent a transporté l'équipement vers la localisation cible correspondante, déterminer (S430), par l'ordinateur hôte de localisation, une tâche de test cible correspondant à l'équipement et délivrer (S440) la tâche de test cible à l'équipement ;
la détermination (S430), par l'ordinateur hôte de localisation, une tâche de test cible correspondant à l'équipement comprenant les étapes consistant à :
obtenir (S431), par l'ordinateur hôte de localisation, un code graphique de l'équipement et déterminer (S432) un type d'équipement de l'équipement sur la base du code graphique ; et
déterminer (S433), par l'ordinateur hôte de localisation, la tâche de test cible correspondante sur la base du type d'équipement.

2. Procédé selon la revendication 1, la détermination (S400), par l'ordinateur hôte de planification, d'une tâche de transport d'équipement pour l'équipement comprenant l'étape consistant à :
recevoir, par l'ordinateur hôte de planification, une localisation spécifiée entrée de l'extérieur et déterminer la tâche de transport d'équipement pour l'équipement sur la base de la localisation spécifiée ; et
le procédé comprenant en outre les étapes consistant à :
après que le dispositif de transport intelligent a transporté l'équipement vers la localisation spécifiée, recevoir (S450), par l'ordinateur hôte de localisation, une tâche de test cible entrée de l'extérieur et délivrer (S460) la tâche de test cible à l'équipement.

3. Procédé selon la revendication 1, le fait de déterminer (S410), par l'ordinateur hôte de planification, si l'équipement satisfait à la tâche de transport d'équipement comprenant les étapes consistant à :
déterminer (S411), par l'ordinateur hôte de planification, si la localisation cible correspondant à l'équipement satisfait à une condition d'admission ;
si la localisation cible satisfait à la condition d'admission, déterminer (S412), par l'ordinateur hôte de planification, si un type d'équipement de l'équipement est un type d'équipement correspondant à une tâche de test en cours ; et
si le type d'équipement de l'équipement est un type d'équipement correspondant à la tâche de test en cours, déterminer (S413) que l'équipement satisfait à la tâche de transport d'équipement.

4. Procédé selon la revendication 3, le fait de déterminer (S412), par l'ordinateur hôte de planification, si un type d'équipement de l'équipement est un type d'équipement correspondant à une tâche de test en cours comprenant les étapes consistant à :
obtenir, par l'ordinateur hôte de planification, le code graphique de l'équipement et déterminer le type d'équipement de l'équipement sur la base du code graphique, afin de déterminer si le type d'équipement de l'équipement est un type d'équipement correspondant à la tâche de test en cours.

5. Procédé selon l'une quelconque des revendications 1 à 4, le procédé comprenant en outre les étapes consistant à :
après l'exécution de la tâche de test cible à la localisation cible, obtenir (S500), par l'ordinateur hôte de planification, des données d'équipement correspondant à la tâche de test cible exécutée par l'équipement ;
déterminer (S510), par l'ordinateur hôte de planification, si les données d'équipement satisfont à une tâche de retour d'équipement ; et
si les données d'équipement satisfont à la tâche de retour d'équipement, donner l'instruction (S520), par l'ordinateur hôte de planification, au dispositif de transport intelligent de retransporter l'équipement vers une localisation d'origine de l'équipement.

6. Système permettant l'exécution d'une tâche d'équipement pour machine de fabrication, comprenant un ordinateur hôte de planification (100), l'ordinateur hôte de planification (100) stockant une heure de début de tâche correspondant à chaque type d'équipement ; et
l'ordinateur hôte de planification (100) étant configuré pour : déterminer une tâche de transport d'équipement pour l'équipement après que l'heure de début de tâche de l'équipement a été atteinte ;
déterminer si l'équipement satisfait à la tâche de transport d'équipement ; et
si l'équipement satisfait à la tâche de transport d'équipement, donner l'instruction à un dispositif de transport intelligent de transporter l'équipement vers une localisation cible correspondante, de manière à exécuter une tâche de test pour l'équipement, la tâche de test comprenant une tâche de test de température ou une tâche de test de pression ;
le système comprenant en outre un ordinateur hôte de localisation (200) configuré pour : après que le dispositif de transport intelligent a transporté l'équipement vers la localisation cible correspondante, déterminer une tâche de test cible correspondant à l'équipement et délivrer la tâche de test cible à l'équipement ; et
l'ordinateur hôte de localisation (200) étant en outre configuré pour :
obtenir un code graphique de l'équipement et déterminer un type d'équipement de l'équipement sur la base du code graphique ; et
déterminer la tâche de test cible correspondante sur la base du type d'équipement.

7. Système selon la revendication 6, l'ordinateur hôte de localisation (200) étant configuré pour : après que le dispositif de transport intelligent a transporté l'équipement vers la localisation cible correspondante, recevoir une tâche de test cible entrée de l'extérieur et délivrer la tâche de test cible à l'équipement.

8. Système selon la revendication 6,
l'ordinateur hôte de planification (100) étant en outre configuré pour déterminer si la localisation cible correspondant à l'équipement satisfait à une condition d'admission ;
l'ordinateur hôte de planification (100) étant en outre configuré pour : si la localisation cible satisfait à la condition d'admission, déterminer si un type d'équipement de l'équipement est un type d'équipement correspondant à une tâche de test en cours ; et
si le type d'équipement de l'équipement est un type d'équipement correspondant à la tâche de test en cours, déterminer que l'équipement satisfait à la tâche de transport d'équipement.

9. Système selon la revendication 6,
l'ordinateur hôte de planification (100) étant en outre configuré pour obtenir le code graphique de l'équipement et déterminer le type d'équipement de l'équipement sur la base du code graphique, afin de déterminer si le type d'équipement de l'équipement est un type d'équipement correspondant à la tâche de test en cours.

10. Système selon l'une quelconque des revendications 6 à 9,
après l'exécution de la tâche de test cible à la localisation cible, l'ordinateur hôte de planification (100) étant en outre configuré pour : obtenir des données d'équipement correspondant à la tâche de test cible exécutée par l'équipement ;
déterminer si les données d'équipement satisfont à une tâche de retour d'équipement ; et
si les données d'équipement satisfont à la tâche de retour d'équipement, donner l'instruction au dispositif de transport intelligent de retransporter l'équipement vers une localisation d'origine de l'équipement.

11. Support de stockage lisible par ordinateur, stockant un programme informatique, le procédé selon l'une quelconque des revendications 1 à 5 étant mis en œuvre lorsque le programme informatique est exécuté par un processeur (103).
